# EUROPÄISCHE PATENTANMELDUNG

(11) **EP 4 300 574 A1**
(43) Veröffentlichungstag der Anmeldung: **03.01.2024**
(21) Anmeldenummer: 22182129.1
(22) Anmeldetag: 30.06.2022
(51) Int. Cl.: H01L 23/498, H01L 25/00

(54) **BESTÜCKBARES LEISTUNGSMODUL**

(71) Anmelder: Siemens Aktiengesellschaft, 80333 München (DE)
(72) Erfinder: Hensler, Alexander, 91466 Gerhardshofen (DE); Pfefferlein, Stefan, 90562 Heroldsberg (DE); Bigl, Thomas, 91074 Herzogenaurach (DE); Heimann, Matthias, 14469 Potsdam (DE); Müller, Bernd, 16259 Falkenberg (DE); Nachtigall-Schellenberg, Christian, 14480 Potsdam (DE); Oschmann, Philipp, 91058 Erlangen (DE); Strogies, Jörg, 14163 Berlin (DE); Wilke, Klaus, 12527 Berlin (DE)
(74) Vertreter: Siemens Patent Attorneys

(57) **Zusammenfassung**

Die Erfindung betrifft ein bestückbares Leistungsmodul (100) umfassend ein Leistungssubstrat (10) mit einer Metallisierung (14,16), zumindest ein schaltbarer Die (40) mit Leistungsanschlüssen (42,44), ein Interposer (50) und zumindest ein erstes und ein zweites Kontaktelement (62,64), wobei die Kontaktelemente (62,64) jeweils eine elektrische Kontaktierung einer der Leistungsanschlüsse (42,44) des Dies (40) am Interposer (50) bereitstellen. Um ein in einer herkömmlichen Fertigungslinie bestückbares Leistungsmodul (100) anzugeben, das ohne Reinraumbedingungen, z. B. in einer SMD-Montagelinie, niederinduktiv an eine Baugruppe (200) angebunden werden kann wird vorgeschlagen, dass der Die (40) an die erste Metallisierung (14) des Leistungssubstrats (10) und an den Interposer (50) gefügt ist und zwischen dem Leistungssubstrat (10) und dem Interposer (50) angeordnet ist, ein sich aus dem ersten Substrat (10), dem Interposer (50) und dem Die (40) bildender Spalt mit einem Isolationsmaterial (20) verschlossen ist, sodass der Die (30) vom Isolationsmaterial (20), dem Leistungssubstrat (10) und dem Interposer (50) umgeben ist und dass der Interposer (50) so ausgestaltet ist, dass ein oder mehrere der Kontaktelemente (62,64) durch den Interposer (50) hindurchragen und/oder der Interposer (50) ein oder mehrere der Kontaktelemente (62,64) bereitstellt. Die Erfindung betrifft weiterhin eine leistungselektronische Baugruppe (200), einen Umrichter sowie ein Elektrofahrzeug.

## Beschreibung

Die Erfindung betrifft ein bestückbares Leistungsmodul, eine leistungselektronische Baugruppe, einen Umrichter sowie ein Elektrofahrzeug

Ein derartiges Leistungsmodul kann in industriellen Umrichtern oder in Traktionsumrichtern zum Einsatz kommen.

Es ist Aufgabe der Erfindung ein in einer herkömmlichen Fertigungslinie bestückbares Leistungsmodul anzugeben, das niederinduktiv an eine Baugruppe angebunden werden kann.

Die Aufgabe wird durch ein bestückbares Leistungsmodul gelöst, das ein Leistungssubstrat mit einer Metallisierung, zumindest einen schaltbaren Die mit Leistungsanschlüssen, einen Interposer und zumindest ein erstes und ein zweites Kontaktelement umfasst. Die Kontaktelemente stellen jeweils eine elektrische Kontaktierung einer der Leistungsanschlüsse des Dies am Interposer bereit und sind dabei zur elektrischen Kontaktierung der Leistungsanschlüsse des Dies mit einer leistungselektronischen Baugruppe ausgebildet. In anderen Worten stellen die Kontaktelemente eine elektrische Kontaktierung der Leistungsanschlüssen des Dies, der innerhalb des Leistungsmoduls angeordnet ist, außerhalb des Leistungsmoduls bereit, sodass das Modul auf einer Baugruppe bestückt werden und zum Einsatz kommen kann. Der Die ist ein Halbleiterbauelement, der beispielsweise als IGBT oder MOSFET ausgebildet sein kann. Es handelt sich dabei um einen ungehäusten Halbleiter und wird auch als Bare Die oder als Nacktchip bezeichnet. Derartige Nacktchips werden normalerweise nur unter Reinraumbedingungen verarbeitet und werden dementsprechend selten direkt in herkömmlichen SMD-Fertigungslinien verarbeitet. Das erfindungsgemäße Modul kann vorteilhaft in herkömmlichen Elektronikfertigungslinien verarbeitet werden und dabei gleichzeitig ähnlich niederinduktiv angebunden werden, wie es mit dem Die selbst möglich wäre.

Die Leistungsanschlüsse des Dies sind dabei in der Regel und je nach Halbleitertyp als Source und Drain bzw. Kollektor und Emitter ausgebildet. Bei Dioden sind die Leistungsanschlüsse als Anode bzw. Kathode ausgebildet. Weiterhin ist der Die an die Metallisierung des Leistungssubstrats und an den Interposer gefügt und zwischen dem Leistungssubstrat und dem Interposer angeordnet. Ein sich aus dem ersten Substrat, dem Interposer und dem Die bildender Spalt ist mit einem Isolationsmaterial verschlossen, sodass der Die vom Isolationsmaterial, dem Leistungssubstrat und dem Interposer umgeben ist. Dies hat den Vorteil, dass der Nacktchip nun so eingekapselt ist, dass er in einer herkömmlichen SMD-Fertigung verarbeitet werden kann. Der Interposer ist dabei so ausgestaltet, dass die Kontaktelemente durch den Interposer hindurchragen und/oder der Interposer die Kontaktelemente bereitstellt.

Die Kontaktelemente sind dabei vorzugsweise so ausgestaltet, dass ein niederinduktiver elektrischer Kontakt von der leistungselektronischen Baugruppe zum Die herstellbar ist. In anderen Worten sind das erste und das zweite Kontaktelement zur Bereitstellung einer elektrischen Kontaktierung von Leistungsanschlüssen des Dies am Interposer ausgestaltet, sodass der Die von außerhalb des Leistungsmoduls elektrisch kontaktiert werden kann.

Die Kontaktelemente können dabei als Teil des Interposers ausgestaltetet sein und mit elektrischen Leitern im Interposer elektrisch kontaktiert sein. Derartige Kontaktelemente sind kommerziell in Leiterplattentechnik erhältlich oder können als Metallisierung des Interposers gefertigt werden.

Erfindungsgemäß wird eine einfache, einseitige und automatisierbare Kontaktierung des Dies über den Interposer ermöglicht. Das bestückbare Leistungsmodul kann dann dementsprechend auf eine leistungselektronische Baugruppe bestückt werden. Das Leistungsmodul weist dabei vorzugsweise einen oder höchstens zwei schaltbare Dies auf.

Der Interposer kann dabei einen größeren thermischen Ausdehnungskoeffizient aufweisen als das Leistungssubstrat. So kann der Interposer aus günstigeren und flexibel und einfach verarbeitbaren Materialien ausgestaltet werden als das Leistungssubstrat.

Die elektrische Kontaktierung und die Handhabung von Dies werden also durch das Leistungsmodul bei dessen Montage erheblich vereinfacht, wobei die Flexibilität des Bare Dies hinsichtlich der elektrischen Verschaltung (Topologien, Leistungsskalierung) und der Anordnung in der Komponente erhalten bleibt.

Die Leistungsmodul und dementsprechend die Kontaktelemente und der Die sind dabei für eine Sperrspannung von zumindest 24 V, insbesondere zumindest 50 V oder 100 V, und einen Laststrom von zumindest 1 A, insbesondere zumindest 5 A oder 10A, ausgelegt.

In einer weiteren Ausführungsform ist das Leistungssubstrat als ein Metall-Keramik-Substrat ausgebildet. Insbesondere sind hier die sogenannten Direct-Bonded-Copper und Active Metal Brazing Substrate zu nennen. Derartige Substrate haben den großen Vorteil, dass ein an den Die angepasster thermischer Ausdehnungskoeffizient vorliegt, womit eine sehr hohe Stabilität, insbesondere gegen thermische Wechselbeanspruchungen, erwirkt wird. Gleichzeitig kann auch eine hohe Wärmeleitung vom Die in Richtung einer thermischen Schnittstelle des Substrats erreicht werden, die dem Die bezüglich des Substrats gegenüberliegt.

In einer weiteren Ausführungsform ist der Interposer als ein mehrlagiger Schaltungsträger ausgebildet. Dies hat den Vorteil, dass die Leitungsführung im mehrlagigen Schaltungsträger sehr viel flexibler gestaltet werden kann, als es beispielsweise ein Keramiksubstrat erlauben würde.

In einer weiteren Ausführungsform ist der Interposer als Kunststoffleiterplatte, insbesondere eine faserverstärkte Kunststoffleiterplatte, eine FR4-Leiterplatte, ein sogenanntes Hoch-Tg-PCB (aufweisend eine Glasübergangstemperatur TG von größer als 150°C), aus Polyimid und/oder als pre-molded leadframe ausgestaltet. Für Hochtemperaturanwendungen haben sich Hochtemperatur-Interposer Materialien wie beispielsweise PI, PEEK oder LCP bewährt.

In einer weiteren Ausführungsform weist der Interposer metallische Inlays auf. Derartige Inlays können insbesondere aus Kupfer ausgebildet, als massive Metallblöcke ausgestaltet sein und führen sowohl zu einer verbesserten Stromtragfähigkeit als auch zu einer verbesserten thermischen Leitfähigkeit beim Anschluss der Leistungsanschlüsse des Dies. Die Inlays sind dabei vorzugsweise elektrisch zumindest mit einem der Leistungsanschlüsse des Dies elektrisch verbunden und können in mehrlagigen Leiterplatten über Vias an den Die angebunden sein. So ist je nach Leistungsanforderung denkbar, dass ein oder mehrere Vias auf jeweils ein metallisches Inlay elektrisch kontaktieren und dann dementsprechend auch aus dem Interposer hinaus die Kontaktelemente bereitstellen bzw. elektrisch kontaktieren. In anderen Worten dienen die Inlays als elektrischer Leiter für die Kontaktelemente, um eine Verbindung zwischen dem Leistungsanschlüssen des Dies und einer leistungselektronischen Baugruppe zu ermöglichen.

In einer weiteren Ausführungsform weist der Interposer eine Aussparung für eines der Kontaktelemente auf, wobei das Kontaktelement elektrisch mit der Metallisierung kontaktiert ist. Da die Dies in der Regel auf Ober- und Unterseite Leistungsanschlüsse aufweisen, müssen der Leistungsanschluss, der mit der Metallisierung des Leistungssubstrats in Kontakt steht umkontaktiert werden, damit ein einseitiger Anschluss des Leistungsmoduls über den Interposer möglich ist. Diese Umkontaktierung kann beispielsweise durch ein durch den Interposer hindurchragendes Kontaktelement geschehen. Hier kann beispielsweise ein Pin vorgesehen sein, der als Anschluss bzw. als Kontaktelement des Leistungsmoduls dient. Dieser Pin kann einpressbar sein und ist auch mechanisch durch eine Verbindung mit dem stabilen Leistungssubstrat gut anbindbar und weist niederinduktive Eigenschaften auf. Als Kontaktelemente kommen vorzugweise massive Anschlüsse zum Einsatz, die auf die anfallende Leistung ausgelegt sind. Ergänzend oder alternativ kann der Pin auch eine elektrische Zwischenkontaktierung am Interposer aufweisen und muss dementsprechend nicht an der Metallisierung des Leistungssubstrates elektrisch kontaktiert sein und kann dort potentialgetrennt oder vollständig isoliert angebracht sein.

In einer weiteren Ausführungsform ist der Interposer so ausgebildet, dass Leistungsanschlüsse und Steueranschlüsse aller Dies auf einer gemeinsamen, dem Leistungssubstrat abgewandten Seite des Interposers bereitgestellt werden. Dies ermöglicht eine einfache Bestückung und dabei eine besonders niederinduktive Anbindung des Leistungsmoduls.

In einer weiteren Ausführungsform ist zumindest eines der Kontaktelemente zur Kontaktierung mittels eines Pressverfahrens, insbesondere mittels eines Einpressverfahrens ausgebildet. Hier kommen flächige Pressverfahren oder auch Einpressverbindungen in Frage. Derartige Kontaktierungsverfahren sind sehr niederinduktiv, gut beherrschbar und können gut verarbeitet werden.

In einer weiteren Ausführungsform ist zumindest eines der Kontaktelemente zur Kontaktierung mit der elektronischen Baugruppe mittels eines Fügeverfahrens ausgebildet. Hier kommen insbesondere Löt-Pins, flächige sinter- und/oder lötbare Anschlusspads (ähnlich eines Land Grid Arrays) oder lötbare Balls (ähnlich einem Ball Grid Array) in Frage. Derartige Fügeflächen sind besonders niederinduktiv und können insbesondere durch den flachen bzw. planaren Aufbau des Leistungsmoduls auch einfach gefügt werden.

In einer weiteren Ausführungsform ist zumindest eines der Kontaktelemente zur Kontaktierung mittels einer Federkraft ausgebildet. Dies hat den Vorteil, dass eine niederinduktive elektrische Verbindung bei gleichzeitiger Lösbarkeit der Verbindung erreicht werden kann.

In einer weiteren Ausführungsform weist der Interposer ein erstes metallisches Inlay auf, das mit einem ersten Leistungsanschluss des Dies und einem ersten Kontaktelement elektrisch kontaktiert ist. Ergänzend oder alternativ weist der Interposer ein zweites metallisches Inlay auf, das mit einem zweiten Leistungsanschluss des Dies und einem zweiten Kontaktelement elektrisch kontaktiert ist. So können die Leistungsanschlüsse über die metallischen Inlays mit einer hohen Stromtragfähigkeit, einer sehr guten thermischen Leitfähigkeit sowie einer niedrigen Induktivität aus dem Leistungsmodul herausgeführt werden.

In einer weiteren Ausführungsform ist der Interposer so ausgestaltet, dass eine Kriechstrecke im Spalt zwischen einer Umkontaktierung des ersten Leistungsanschlusses und des zweiten Leistungsanschlusses des Dies kleiner ist als eine Luftstrecke zwischen dem ersten Kontaktelement und dem zweiten Kontaktelement. Die aus dem Leistungsmodul herausgeführten und durch den Interposer bereitgestellten Kontaktelemente haben so vorzugsweise an der Luft (d.h. an den von außerhalb des Leistungsmoduls zugänglichen Kontaktelemente) einen deutlich größeren Abstand als es die Platzverhältnisse im Leistungsmodul bzw. im direkten Umfeld des Dies erlauben würden. Eine derartige Entzerrung wirkt sich wiederum positiv auf die Leistungsfähigkeit und die Leistungsdichte des Leistungsmoduls aus und erlaubt einen Verzicht auf ein weiteres Isolationsmaterial außerhalb des Leistungsmoduls oder ermöglicht die Verwendung von günstigeren Isolationsmaterialien. Die Entzerrung der Kriech- und Luftstrecke lässt sich dabei mit und ohne Inlay realisieren.

In einer weiteren Ausführungsform weist der Interposer einen Steueranschluss auf, der einen Steueranschluss des Dies elektrisch kontaktiert. Der Steueranschluss des Interposers kann dabei zwischen dem ersten und dem zweiten Kontaktelement angeordnet sein. Dies ist nicht nur platzsparend, sondern verändert auch die Isolationsanforderungen nicht, da der Steueranschluss auf einem von den Leistungsanschlüssen verschiedenen Potential liegt. Somit kann sehr kompakt gebaut werden.

Die Aufgabe wird weiterhin durch eine leistungselektronische Baugruppe gelöst, die zumindest ein Baugruppensubstrat und zumindest zwei erfindungsgemäße Leistungsmodule aufweist, wobei die Leistungsmodule mit dem Baugruppensubstrat elektrisch kontaktiert sind. Das Baugruppensubstrat kann durch den erfindungsgemäßen Aufbau der Leistungsmodule als herkömmliche (z. B. FR4) Leiterplatte ausgestaltet sein, da eine Wärmeableitung über die Leistungssubstrate der Leistungsmodule, die dem Baugruppensubstrat abgewandt angeordnet sind, erfolgt und eine Entzerrung der Leistungsdichte durch den Interposer stattfindet.

Die leistungselektronische Baugruppe kann in einer weiteren Ausführungsform so ausgestaltet sein, dass die Interposer der Leistungsmodule dem Baugruppensubstrat zugewandt angeordnet sind. In anderen Worten stellt der Interposer mit den Kontaktelementen die elektrische Kontaktierung für das Baugruppensubstrat bereit.

In einer weiteren Ausführungsform sind die Leistungsmodule zwischen dem Baugruppensubstrat und einem Kühlkörper angeordnet. Das heißt der Interposer zeigt in Richtung des Baugruppensubstrates und das Leistungssubstrat des Leistungsmoduls kann beispielsweise mit einer thermischen Schnittstelle direkt mit dem Kühlkörper verbunden werden. Der Kühlkörper kann dabei auch dazu dienen, eine ebene Verbindung bezüglich der Leistungssubstrate und der Modulausrichtung untereinander sicherzustellen.

Im Vergleich mit vollintegrierten Lösungen kommerziell erhältlicher Leistungsmodule mit 4 oder 6 schaltbaren Halbleitermodulen (z. B. sogenannte Sixpack Module) bietet die vorliegende Erfindung im Allgemeinen und ihre Ausführungsformen im Speziellen viele Vorteile. Das Leistungsmodul ist ein modulares Package mit standardisierbaren Anschlüssen. Änderungen beim Leistungshalbleiter (unterschiedliche Leistungshalbleitertechnologien wie z. B. IGBTs, MOSFETs, SiC, GaN) betreffen das Leistungsmodul selbst, der Interposer könnte also anschlussseitig gleichbleiben. Das Powerboard (d.h. das Baugruppensubstrat) muss nicht geändert werden. Anpassungen der Leistung oder der Schaltungstopologie können bei identischem Powerboard über unterschiedliche Leistungsmodule mit entsprechend unterschiedlichen Leistungshalbleitern bzw. Verschaltungen realisiert werden.

Layoutänderungen (z. B. Verschieben der Bestückpositionen) am Powerboard können durch standardisierte Anschlussstrukturen des erfindungsgemäßen Leistungsmoduls einfach umgesetzt werden. Hinsichtlich der Auslegung einer leistungselektronischen Baugruppe hat das erfindungsgemäße Leistungsmodul den Vorteil, dass es als diskretes Bauelement beim Schaltungsdesign angesehen und dementsprechend direkt mit beim Layout geplant werden kann. Jedes einzelne Leistungsmodul ist und bleibt vollständig elektrisch prüfbar. Im Gegensatz zu mehreren Halbleitern auf einem Schaltungsträger, die nur als Gesamtgebilde prüfbar sind, lässt sich der Yield dadurch erheblich steigern.

Für die thermische Entkopplung zwischen Leistungsmodul und Powerboard ist die benötigte Fläche für potenziell kostenintensives Hochtemperatur-Interposermaterial wird auf ein Minimum beschränkt. Für das Powerboard kann vorzugsweise kostengünstiges Standardmaterial verwendet werden.

Besonders vorteilhaft ist es, dass eine Nivellierung der einzelnen Leistungsmodule zueinander bzw. untereinander und zum Kühlkörper sich elegant durch Einpressen oder Einlöten mit Niederhaltern oder durch ausgleichende Verbindungselemente erreichen lässt. In der leistungselektronischen Baugruppe können also die einzelnen thermischen Interfaces der Leistungsmodule zueinander in einer Ebene, innerhalb einer vorgebbaren Toleranz, ausgerichtet sein.

Die Aufgabe wird weiterhin gelöst durch einen Umrichter, der zumindest eine leistungselektronische Baugruppe aufweist, sowie ein Elektrofahrzeug, dass einen derartigen Umrichter aufweist. Weiterhin kann die leistungselektronische Baugruppe auch als DC/DC-Wandler ausgestaltet sein.

Im Folgenden wird die Erfindung anhand der in den Figuren dargestellten Ausführungsbeispiele näher beschrieben und erläutert. Es zeigen jeweils schematisch:
- FIG 1: ein Leistungsmodul im Querschnitt
- FIG 2: ein weiteres Leistungsmodul im Querschnitt mit Kontaktelementen,
- FIG 3: ein weiteres Leistungsmodul im Querschnitt mit weiteren Kontaktelementen,
- FIG 4: eine ergänzende Ausführungsform des Leistungsmoduls mit durch den Interposer hindurchragendem Pin,
- FIG 5: eine Ausführungsform mit zwei durch den Interposer hindurchragenden Pins,
- FIG 6: eine Darstellung von Luft- und Kriechstrecken an einem Leistungsmodul,
- FIG 7: ein Leistungsmodul mit einem Interposer, der Inlays aufweist,
- FIG 8: ein Leistungsmodul mit einem Interposer, der Inlays aufweist, in einer Ausführungsform mit einem Steueranschluss,
- FIG 9: eine einseitig leistungselektronische Baugruppe und
- FIG 10: eine beidseitig bestückte leistungselektronische Baugruppe.

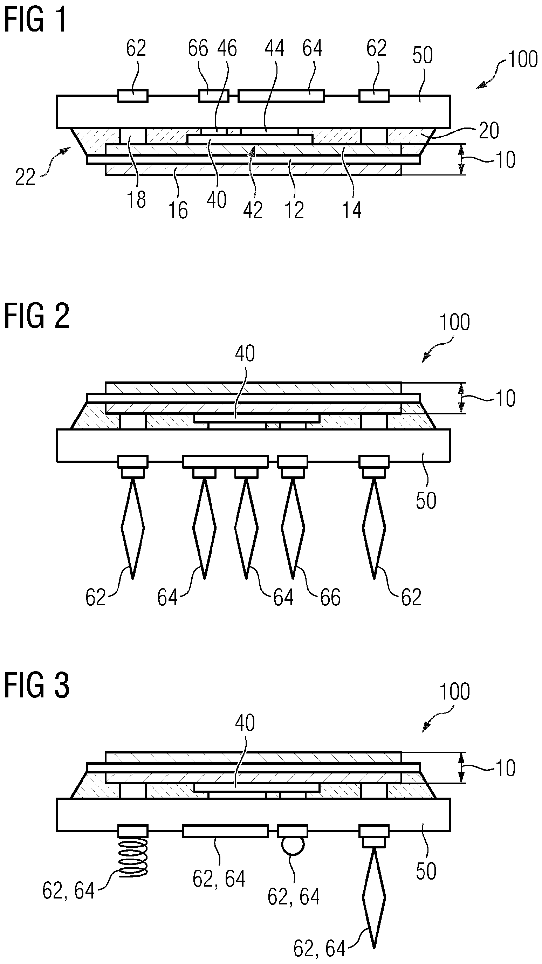

FIG 1 zeigt ein Leistungsmodul 100, das ein Leistungssubstrat 10 mit einem insbesondere keramischen Kern 12, eine erste Metallisierung 14 und einer zweiten Metallisierung 16, aufweist. An die erste Metallisierung 14 ist ein Die 40, in diesem Fall ein schaltbarer Die 40, angebracht, beispielsweise gefügt. Der Die 40 ist dabei mit seinem ersten Leistungsanschluss 42 an die erste Metallisierung 14 angebracht und elektrisch kontaktiert, sodass über ein oder mehrere Umkontaktierungen 18 eine elektrische Verbindung zwischen dem ersten Leistungsanschluss des Dies 42 mit einem Interposer 50 hergestellt werden kann. Der Interposer 50 weist dabei Kontaktelemente 62,64 auf, die den ersten Leistungsanschluss des Dies 42 mit dem ersten Kontaktelement 62, hier aufgeteilt auf zwei Pads, einen zweiten Leistungsanschluss des Dies 44 durch das zweite Kontaktelement 64 und einen Steueranschluss 46 durch einen Steueranschluss 66 des Interposers 50 elektrisch bereitstellen. Alle Anschlüsse des Dies 40 sind somit am Interposer durch Kontaktelemente 62,64 und den Steueranschluss 66 bereitgestellt.

Der Interposer 50 ist in diesem Fall nur schematisch dargestellt. Unterhalb des Interposers 50 befindet sich ein Isolationsmaterial 20, das einen Spalt 22 zwischen dem Interposer 50, dem Leistungssubstrat 10 und dem Die 40 ausfüllt. Auch die Umkontaktierungen 18 sind vom Isolationsmaterial 20 umgeben. Hier kann beispielsweise ein Underfill-Material oder ein Molding zum Einsatz kommen. Vorteilhaft ist es, wenn nur ein einzelnes IGBT mit der dazugehörigen Freilaufdiode oder nur eine geringe Anzahl von parallel geschalteten MOSFETs auf einem der Leistungssubstrate 10 angebracht ist, um eine möglichst hohe Flexibilität zu erreichen.

FIG 2 zeigt ein Leistungsmodul 100, wie es in FIG 1 gezeigt wurde, wobei die Kontaktelemente 62,64 sowie der Steueranschluss 66 bereits Einpress-Pins aufweisen. Alternativ könnten hier Löt-Pins oder Niete vorgesehen sein. Derartige Kontaktelemente sind einfach verarbeitbar und können in Standardprozessen eingesetzt werden.

FIG 3 zeigt eine alternative Ausführungsform eines Leistungsmoduls, wobei am Interposer 50 nun als Kontaktelemente 62,64 neben dem Einpress- bzw. Löt-Pin auch ein Lot-Pad bzw. ein Lot-Ball vorgesehen ist. Derartige Lötverbindungen sind z. B. von Ball-Grid-Arrays bekannt, wobei im vorliegenden Fall eine Leistungsverbindung durch eine entsprechende Anzahl an Balls / die Größe der Pads zustande kommt. Weiterhin denkbar sind flächige Pads und/oder Federverbindungen. Die Verbindungselemente sind dabei kombinierbar, in der Regel werden aber eine Art von Verbindungselementen für alle Verbindungen am jeweiligen Leistungsmodul verwendet.

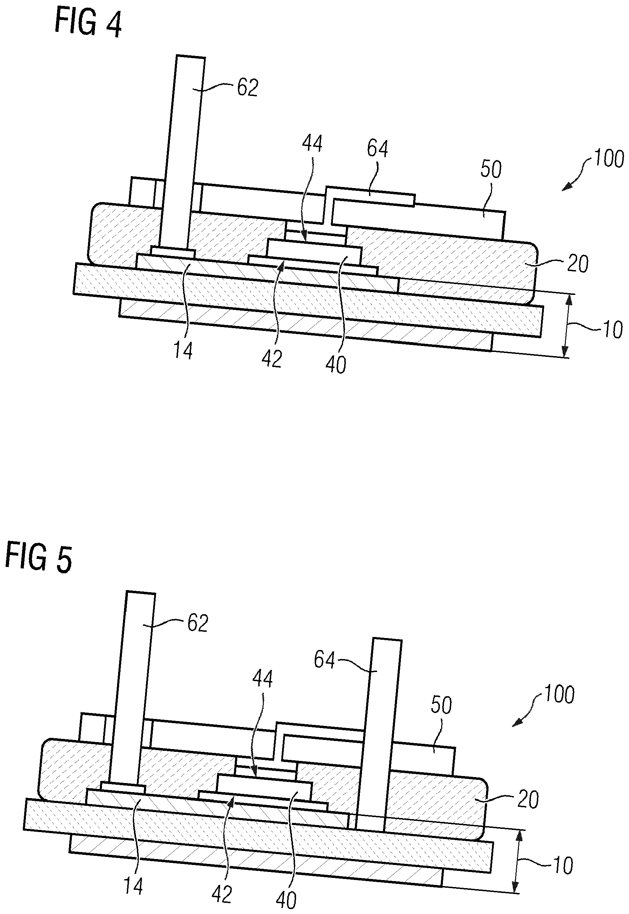

FIG 4 zeigt eine weitere Ausführungsform eines Leistungsmoduls 100, bei dem ein erstes Kontaktelement 62 durch den Interposer 50 hindurchragt. Der Kontakt-Pin bzw. das Kontaktelement 62 ist dabei so ausgestaltet, dass es auf einer Metallisierung 14, die mit einem ersten Leistungsanschluss 42 des Dies 40 verbunden ist, auf einem Leistungssubstrat 10 aufgebracht ist. Auf diese Art und Weise ist keine Umkontaktierung notwendig und eine sehr niederinduktive Verbindung zur Metallisierung 14 bzw. der Chipunterseite und dem dort angeordneten ersten Leistungsanschluss 42 wird geschaffen. Auch in diesem Fall ist der Die 40 mit einem Underfill bzw. einem Molding umgeben, das als Isolationsmaterial 20 wirkt. Derartige Kontakt-Pins können direkt bei der Fertigung der Metallisierung der DCB oder AMB Substraten angebracht werden. Eine zweites Kontaktelement 64 kann wie beschrieben ausgestaltet sein und ist hier als eine Fläche angedeutet. Der zweite Leistungsanschluss 44 ist durch einen elektrischen Leiter im Interposer 50 mit einem zweiten Kontaktelement 64 verbunden. Das zweite Kontaktelement 64 kann dabei wie in den Ausführungsformen zu den Kontaktelementen unterschiedlich und je nach Anwendung ausgestaltet sein. Der Die 40 ist dabei mit seinen Leistungsanschlüssen 42,44 an das Substrat bzw. an den Interposer 50 gefügt. Der Die 40 kann dabei auch einen Steueranschluss aufweisen, der hier nicht gezeigt ist.

FIG 5 zeigt eine Ausführungsform ähnlich der FIG 4, wobei das erste und das zweite Kontaktelement 62,64 jeweils als Pin ausgebildet sind, wobei das erste Kontaktelement 62 wie in FIG 4 ausgestaltet ist und mit dem ersten Leistungsanschluss 42 des Dies 40 elektrisch kontaktiert ist. Das zweite Kontaktelement 64 ist ebenfalls als Pin ausgebildet, der über den Interposer 50 mit einem zweiten Leistungsanschluss 44 des Dies 40 kontaktiert ist. Das zweite Kontaktelement 64 kann dabei wie gezeigt direkt auf dem Kern des Substrats 10 angeordnet sein, kann aber ebenso auf einer elektrisch isolierten Insel der Metallisierung 14 angebracht sein. Der Die 40 kann dabei auch einen Steueranschluss aufweisen, der hier nicht gezeigt ist.

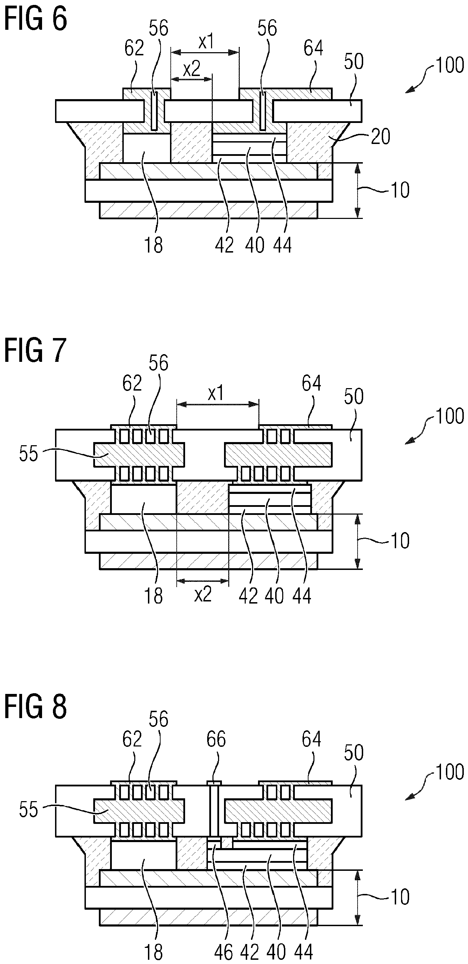

FIG 6 zeigt eine weitere Ausführungsform eines Leistungsmoduls 100, wobei hier eine Luftstrecke x1 und eine Kriechstrecke x2 eingezeichnet sind. Die Luftstrecke x1 befindet sich außerhalb des Leistungsmoduls 100 zwischen einem ersten Kontaktelement 62 und einem zweiten Kontaktelement 64. Die Luftstrecke x1 ist dabei die Entfernung, die als Isolation an der Luft bzw. in dem Fluid in dem das Leistungsmodul 100 eingesetzt wird, zwischen den beiden leistungsführenden Kontaktelementen 62,64 vorgesehen ist. Diese Strecke muss groß genug sein, um Isolationsanforderungen in der jeweiligen Leistungsklasse zu erfüllen. In dieser besonders vorteilhaften Ausführungsform ist die Luftstrecke x1 größer als eine Kriechstrecke x2, die sich innerhalb eines Isolationsmaterials 20 befindet. Die Aufspreizung der Luftstrecke x1 bezüglich der Kriechstrecke x2 wird dabei durch den Interposer 50 bzw. die dadurch angeordneten Kontaktelemente 64, 62 ermöglicht. Das Kontaktelement 62 verbindet dabei eine Umkontaktierung 18, die über eine Metallisierung des Leistungssubstrates 10 mit dem ersten Leistungsanschluss 42 des Halbleiters 40 verbunden ist und ein zweites Kontaktelement 64, das ebenfalls über den Interposer 50 mit einem zweiten Leistungsanschluss 44 des Halbleiters bzw. des Dies 40 verbunden ist. Über Vias 56 werden dabei die Unterseite und die Oberseite des Interposers derart verbunden, dass die Luftstrecke x1 erheblich größer ist als die Kriechstrecke x2. Der Interposer dient dabei als flexibel gestaltbare Zwischenlage, die die Leistungsanschlüsse 62 und 64 entsprechend aufspreizt. Nicht eingezeichnet sind Steueranschlüsse des Dies 40, die aber ebenso über den Interposer herausgeführt werden können.

FIG 7 zeigt eine Ausführungsform ähnlich der FIG 6, wobei ein mehrlagiger Interposer 50 verwendet wird, der metallische Inlays 55 aufweist, die gleichzeitig der besseren und sehr niederinduktiven elektrischen Kontaktierung dienen und eine Aufspreizung zwischen Luft- und Kriechstrecke x1, x2 ermöglichen. Die Inlays sind dabei vorzugsweise als eine dicke Kupferlage im Zentrum ausgebildet, welche mit den zwei äußeren Lagen über Vias kontaktiert sind. Die Inlays bieten eine sehr gute thermische Anbindung und auch eine ausgezeichnete niederohmige vertikale Stromdurchführung. Die Vias können insbesondere als lasergebohrte Vias, welche mit Kupfer verfüllt werden, ausgebildet sein. Die dadurch entstehende Entzerrung der Lastströme direkt am Halbleiter bzw. direkt am Die 40 ermöglicht ein optimiertes Konzept und die Verwendung von standardgemäßen Multilayer-PCBs.

FIG 8 zeigt eine weitere Ausführungsform eines Leistungsmoduls 100 mit einem Interposer 50, der Inlays 55 aufweist, ähnlich der FIG 6. Hier ist zu sehen, wie ein Die 40, der einen Steueranschluss 46 aufweist, mit durch den Interposer 50 kontaktiert werden kann. Ein Steueranschluss 66 des Interposers 50 ist über ein Via durch den mehrlagigen Interposer 50 mit dem Steueranschluss 46 des Dies 40 verbunden. Eine derartige Anordnung ist weiterhin vorteilhaft, da der Steueranschluss 66 die Aufteilung der Luft- und Kriechstrecken x1, x2 (hier nicht eingezeichnet) nicht beeinträchtigt, da der Steueranschluss 66 dementsprechend auf einem anderen Potenzial liegt. Die Anordnung des Steueranschluss 66 ist unabhängig von den Inlays 55.

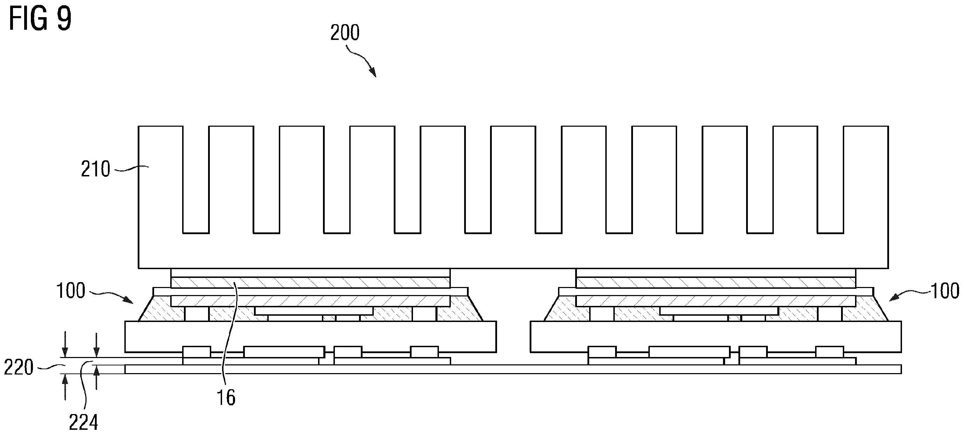

FIG 9 zeigt schematisch eine leistungselektronische Baugruppe 200, die zwei Leistungsmodule 100, einen Kühlkörper 210 sowie ein Baugruppensubstrat 220 mit einer Metallisierung 224 aufweist. Das Baugruppensubstrat 220 kann dabei aus bekannten Materialien für die Leiterplattentechnik hergestellt sein, da die leistungsintensiven Bauteile auf die Leistungsmodule 100 ausgelagert sind. Somit lassen sich sehr flexibel auf die verschiedensten Anwendungen Baugruppen 200 designen und auch für Hochleistungsanwendungen entwärmen.

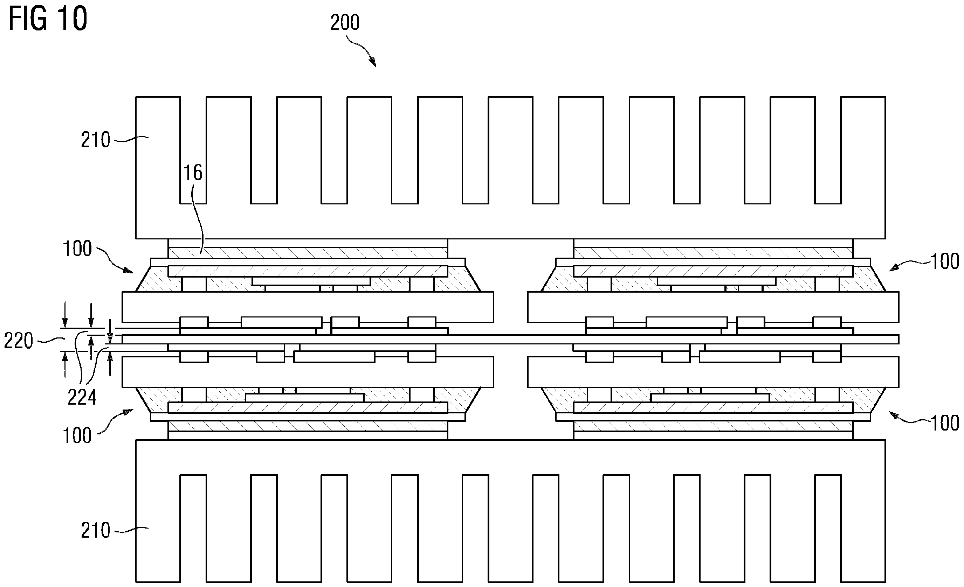

FIG 10 zeigt schematisch eine leistungselektronische Baugruppe 200, wie in FIG 9 wobei das Baugruppensubstrat 220 beidseitig mit jeweils zwei Leistungsmodulen 100 bestückt und kontaktiert ist. So kann eine sehr hohe Leistungsdichte erreicht werden, da die Anbindung der Leistungsmodule 100 an das Baugruppensubstrat 220, z.B. über eine beidseitige Metallisierung 224 weiterhin sehr niederinduktiv realisiert werden kann und gleichzeitig die Wärmabfuhr über die beidseitig angeordneten Kühlkörper effektiv realisiert wird. Allgemein gilt, dass die leistungselektronische Baugruppe 200 und das Baugruppensubstrat 220 so ausgebildet sind, dass die Kontaktelemente 62,64 der Leistungsmodule 100 jeweils Fügepartner auf dem Baugruppensubstrat 220 finden. Dabei kann es sich um entsprechende Buchsen oder Gegenstücke zu den entsprechenden Kontaktelementen 62,64 handeln.

Zusammenfassend betrifft die Erfindung ein bestückbares Leistungsmodul 100 umfassend ein Leistungssubstrat 10 mit einer Metallisierung 14,16, zumindest ein schaltbarer Die 40 mit Leistungsanschlüssen 42,44, ein Interposer 50 und zumindest ein erstes und ein zweites Kontaktelement 62,64, wobei die Kontaktelemente 62,64 jeweils eine elektrische Kontaktierung einer der Leistungsanschlüsse 42,44 des Dies 40 am Interposer 50 bereitstellen. Um ein in einer herkömmlichen Fertigungslinie bestückbares Leistungsmodul 100 anzugeben, das ohne Reinraumbedingungen, z. B. in einer SMD-Montagelinie, niederinduktiv an eine Baugruppe 200 angebunden werden kann wird vorgeschlagen, dass der Die 40 an die erste Metallisierung 14 des Leistungssubstrats 10 und an den Interposer 50 gefügt ist und zwischen dem Leistungssubstrat 10 und dem Interposer 50 angeordnet ist, ein sich aus dem ersten Substrat 10, dem Interposer 50 und dem Die 40 bildender Spalt mit einem Isolationsmaterial 20 verschlossen ist, sodass der Die 30 vom Isolationsmaterial 20, dem Leistungssubstrat 10 und dem Interposer 50 umgeben ist und dass der Interposer 50 so ausgestaltet ist, dass ein oder mehrere der Kontaktelemente 62,64 durch den Interposer 50 hindurchragen und/oder der Interposer 50 ein oder mehrere der Kontaktelemente 62,64 bereitstellt. Die Erfindung betrifft weiterhin eine leistungselektronische Baugruppe 200, einen Umrichter sowie ein Elektrofahrzeug.

### Bezugszeichen

- 100: bestückbares Leistungsmodul
- 10: Leistungssubstrat
- 12: Kern
- 14: erste Metallisierung des Leistungssubstrats
- 16: Zweite Metallisierung des Leistungssubstrats und thermisches Interface
- 18: Umkontaktierung
- 20: Isolationsmaterial
- 22: Spalt

- 40: schaltbarer Die
- 42: erster Leistungsanschluss des Dies
- 44: zweiter Leistungsanschluss des Dies
- 46: Steueranschluss des Dies
- 50: Interposer
- 55: metallisches Inlay
- 56: Via

- 62: erstes Kontaktelement
- 64: zweites Kontaktelement
- 66: Steueranschluss des Interposers

- 200: leistungselektronische Baugruppe
- 210: Kühlkörper
- 220: Baugruppensubstrat
- 224: Metallisierung des Baugruppensubstrats

## Patentansprüche

1. Bestückbares Leistungsmodul (100) umfassend:
- ein Leistungssubstrat (10) mit zumindest einer ersten Metallisierung (14),
- zumindest ein schaltbarer Die (40) mit Leistungsanschlüssen (42,44),
- ein Interposer (50) und
- zumindest ein erstes und ein zweites Kontaktelement (62,64), die jeweils eine elektrische Kontaktierung einer der Leistungsanschlüsse (42,44) des Dies (40) am Interposer (50) bereitstellen,
wobei der Die (40) an die Metallisierung (14) des Leistungssubstrats (10) und an den Interposer (50) gefügt ist und zwischen dem Leistungssubstrat (10) und dem Interposer (50) angeordnet ist,
wobei ein sich aus dem ersten Substrat (10), dem Interposer (50) und dem Die (40) bildender Spalt (22) mit einem Isolationsmaterial (20) verschlossen ist, sodass der Die (30) vom Isolationsmaterial (20), dem Leistungssubstrat (10) und dem Interposer (50) umgeben ist,
wobei der Interposer (50) so ausgestaltet ist, dass ein oder mehrere der Kontaktelemente (62,64) durch den Interposer (50) hindurchragen und/oder der Interposer (50) ein oder mehrere der Kontaktelemente (62,64) bereitstellt.

2. Leistungsmodul (100) nach Anspruch 1, wobei das Leistungssubstrat (10) ein Metall-Keramik-Substrat ist, insbesondere ein Direct-Bonded-Copper- oder ein Active-Metal-Brazing-Substrat.

3. Leistungsmodul (100) nach Anspruch 1 oder 2, wobei der Interposer (50) als ein mehrlagiger Schaltungsträger ausgebildet ist.

4. Leistungsmodul (100) nach einem der vorhergehenden Ansprüche, wobei der Interposer als Kunststoff-Leiterplatte, insbesondere aufweisend ein oder mehrere Bestandteile aus der Gruppe faserverstärkte Kunststoffe, FR4, high TG PCB, Polyimid und/oder als premolded Leadframe, ausgebildet ist.

5. Leistungsmodul (100) nach einem der vorhergehenden Ansprüche, wobei der Interposer (50) metallische Inlays (55) aufweist, insbesondere Kupfer-Inlays, die mit zumindest einem der Kontaktelemente (62,64) elektrisch kontaktiert sind.

6. Leistungsmodul (100) nach einem der vorhergehenden Ansprüche, wobei der Interposer (50) eine Aussparung für eines der Kontaktelemente (62,64) aufweist, das elektrisch mit der ersten Metallisierung (14) kontaktiert ist.

7. Leistungsmodul (100) nach einem der vorhergehenden Ansprüche, wobei der Interposer (50) so ausgebildet ist, dass Leistungsanschlüsse (42,44) und Steueranschlüsse (46) aller Dies (40) auf einer gemeinsamen, dem Leistungssubstrat (10) abgewandten Seite des Interposers bereitgestellt werden.

8. Leistungsmodul (100) nach einem der vorhergehenden Ansprüche, wobei zumindest eines der Kontaktelemente (62,64) zur Kontaktierung mittels eines Pressverfahrens, insbesondere eines Einpressverfahrens, ausgebildet ist.

9. Leistungsmodul (100) nach einem der vorhergehenden Ansprüche, wobei zumindest eines der Kontaktelemente (62,64) zur Kontaktierung mittels eines Fügeverfahrens ausgebildet ist.

10. Leistungsmodul (100) nach einem der vorhergehenden Ansprüche, wobei zumindest eines der Kontaktelemente (62,64) zur Kontaktierung mittels einer Federkraft ausgebildet ist.

11. Leistungsmodul (100) nach einem der vorhergehenden Ansprüche, wobei der Interposer (50) ein erstes metallisches Inlay (55) aufweist, das mit einem ersten Leistungsanschluss (42) des Dies (40) und einem ersten Kontaktelement (62) elektrisch kontaktiert ist.

12. Leistungsmodul (100) nach einem der vorhergehenden Ansprüche, wobei der Interposer (50) ein zweites metallisches Inlay (55) aufweist, das mit einem zweiten Leistungsanschluss (44) des Dies (40) und einem zweiten Kontaktelement (64) elektrisch kontaktiert ist.

13. Leistungsmodul (100) nach einem der vorhergehenden Ansprüche, wobei der Interposer (50) so ausgestaltet ist, dass eine Kriechstrecke (x2) im Spalt (22) zwischen einer Umkontaktierung (18) der elektrischen Kontaktierung des ersten Leistungsanschlusses (42) und des zweiten Leistungsanschlusses (44) des Dies (40) kleiner ist als eine Luftstrecke (x1) zwischen dem ersten Kontaktelement und dem zweiten Kontaktelement (44), die aus dem Interposer (50) geführt werden.

14. Leistungsmodul (100) nach einem der vorhergehenden Ansprüche, wobei der Interposer (50) einen Steueranschluss (66) aufweist, der einen Steueranschluss (46) des Dies elektrisch kontaktiert, wobei der Steueranschluss (66) des Interposers (50) vorzugsweise zwischen dem ersten und dem zweiten Kontaktelement (62,64) angeordnet ist.

15. Leistungselektronische Baugruppe (200) aufweisend ein Baugruppensubstrat (220), mit dem zumindest zwei der Leistungsmodule (100) nach einem der vorhergehenden Ansprüche elektrisch kontaktiert sind.

16. Leistungselektronische Baugruppe (200) nach Anspruch 15, wobei die Leistungsmodule (100) mit ihren Interposern (50) dem Baugruppensubstrat (220) zugewandt angeordnet sind.

17. Leistungselektronische Baugruppe (200) nach Anspruch 15 oder 16, wobei die Leistungsmodule (100) zwischen dem Baugruppensubstrat (220) und einem Kühlkörper (210) angeordnet sind.

18. Leistungselektronische Baugruppe (200) nach einem der Ansprüche 15 bis 17, wobei das Baugruppensubstrat (220) zwischen zumindest zwei jeweils an verschiedenen Seiten des Baugruppensubstrats (220) angeordnete Leistungsmodule (100) aufweist.

19. Umrichter aufweisend zumindest eine leistungselektronische Baugruppe (200) nach einem der Ansprüche 15 bis 18, die zum Wandeln von Gleichspannung in Wechselspannung und/oder umgekehrt ausgebildet ist.

20. Elektrofahrzeug aufweisend einen Umrichter nach Anspruch 19 als Teil eines elektrischen Antriebs.
